(19) Europäisches Patentamt
European Patent Office
Office européen des brevets

(11) **EP 3 194 831 B1**

(12) **EUROPÄISCHE PATENTSCHRIFT**

(45) Veröffentlichungstag und Bekanntmachung des Hinweises auf die Patenterteilung:
**16.02.2022 Patentblatt 2022/07**

(21) Anmeldenummer: **15738055.1**

(22) Anmeldetag: **13.07.2015**

(51) Internationale Patentklassifikation (IPC):
*F16P 3/14* (2006.01)   *H03K 17/955* (2006.01)

(52) Gemeinsame Patentklassifikation (CPC):
**H03K 17/955; F16P 3/148; G01V 3/088**

(86) Internationale Anmeldenummer:
**PCT/EP2015/065927**

(87) Internationale Veröffentlichungsnummer:
**WO 2016/041653 (24.03.2016 Gazette 2016/12)**

(54) **KAPAZITIVER SENSOR**

CAPACITIVE SENSOR

CAPTEUR CAPACITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.09.2014 DE 102014218535**

(43) Veröffentlichungstag der Anmeldung:
**26.07.2017 Patentblatt 2017/30**

(73) Patentinhaber: **Robert Bosch GmbH**
**70442 Stuttgart (DE)**

(72) Erfinder:
• **HARTMANN, Volker**
**73547 Lorch (DE)**
• **EISENHARDT, Volker**
**71277 Rutesheim (DE)**
• **WENZEL, Norbert**
**71277 Rutesheim (DE)**
• **SCHUPP, Dietrich**
**71287 Weissach (DE)**
• **GAESSLEIN, Frank**
**71334 Waiblingen (DE)**
• **FRANGEN, Joachim**
**74081 Heilbronn (DE)**

(56) Entgegenhaltungen:
WO-A1-2013/058708    WO-A2-2011/130755
US-A- 4 125 783    US-A1- 2006 097 734
US-A1- 2010 026 656    US-A1- 2010 079 153
US-A1- 2013 106 702    US-A1- 2013 342 224

**Beschreibung**

Stand der Technik

Die Erfindung betrifft einen kapazitiven Sensor zur flächigen Erkennung der Annäherung eines Objektes.

Aus der DE 10 2009 029 021 A1 und der DE 10 2010 064 328 A1 ist ein Sensorsystem und ein Auswerteverfahren zur Umfeldüberwachung an einem mechanischen Bauteil mit mindestens einem kapazitiven Sensorelement bekannt, wobei das kapazitive Sensorelement an der Oberfläche von Maschinen oder Maschinenteilen anbringbar ist. Das kapazitive Sensorelement besteht aus einem Schichtaufbau von flexiblen elektrisch leitfähigen und elektrisch isolierenden Lagen. Dabei bilden mehrere aneinandergereihte kapazitive Sensorelemente eine Sensorhaut, die wie eine Jacke über ein abzusicherndes Maschinenteil gezogen werden kann.

Die Druckschrift US 2006 097734 A1 beschreibt einen Näherungssensor, der einen Kapazitätssensor verwendet. Insbesondere umfasst der Näherungssensor eine Erfassungsantenne mit zahlreichen Kapazitäten Sensoren, die jeweils eine Meßelektrode umfasst.

In der Druckschrift US 2013 1067 02 A1, ist eine Vorrichtung zur Erfassung eine Annäherung offenbart, wobei die Vorrichtung eine Tastaturfunktion aufweist. Diese Vorrichtung umfasst ein Substrat, eine Erfassungsschaltung, eine Tasteneinheit und eine Hauptsteuereinheit. Die Vorrichtung ist ausgebildet, eine Annäherung mittels der Erfassungsschaltung und der Hauptsteuereinheit zu erfassen, wobei eine erfasste Annäherung als ein Tastendruck verstanden wird, wenn die erfasste Position einer Tasten entspricht.

Aus der US2013342224 ist ein Sensorsystem zur Überwachung der Umgebung einer mechanischen Komponente bekannt. Dieses System weist mindestens einen kapazitiven Sensor auf. Die US 2010 026 656 beschreibt einen kapazitiven Sensor hinter einer Maske.

Offenbarung der Erfindung

Vorteile der Erfindung

Der erfindungsgemäße kapazitive Sensor mit den Merkmalen des unabhängigen Anspruchs zeichnet sich durch einen stabilen Aufbau aus. Dies hat den Vorteil, dass hierdurch große und starre kapazitive Sensoren herstellbar sind, die schnell und sicher auf die Maschinenteile, insbesondere auf ein mechatronisches System oder ein Handlinggerät, insbesondere auf eine Linearachse, auf einen Roboter, auf ein Transportsystem oder auf einen Greifer eines Roboters, montierbar sind. Ferner hat der erfindungsgemäße kapazitive Sensor den Vorteil, dass eingebaute, kapazitive Sensoren leicht auswechselbar sind. Zudem sind einfache Modultests im demontierten Zustand möglich.

Bevorzugte Ausführungsformen werden in den abhängigen Ansprüchen definiert.

Die Steifigkeit ist eine Größe, die angibt, welchen Widerstand ein Körper gegen eine Verformung durch äußere Einwirkung leisten kann. Abhängig von der Art der äußeren Einwirkung wird unter anderem zwischen Biegesteifigkeit und Torsionssteifigkeit unterschieden. Die Biegesteifigkeit ist dabei als Produkt aus dem Flächenträgheitsmoment $I_F$ und dem Elastizitätsmodul E definiert. Die Biegesteifigkeit hängt somit sowohl von der Querschnittsform (Formgebung des Bauteils) als auch von dem Material selbst (Elastizitätsmodul) ab. Demgegenüber ist die Torsionssteifigkeit als Produkt aus dem Torsionsträgheitsmoment $I_T$ und dem Werkstoffschubmoduls G definiert. Somit ist die Torsionssteifigkeit ebenfalls Bauteil- und Materialabhängig. Alternativ wird die Steifigkeit über das mittlere Elastizitäts-Modul und die Dicke definiert. Bei einer Gesamtdicke des biegesteifen und/oder torsionssteifen Materials von 2 mm, weist Polyethylen mit einem Elastizitäts-Modul von 200 MPa bereits eine Biegefestigkeit oder Torsionssteifigkeit auf, während Polycarbonat mit einem Elastizitäts-Modul von 2400 MPa ebenfalls biegesteif und/oder torsionssteif ist. Stahl mit einem Elastizitätsmodul von 210000 Mpa ist bei einer Dicke von 2 mm ebenfalls biegesteif und/oder torsionssteif. Der Kapazitive Sensor ist dann biegesteif und/oder torsionssteif, wenn das Produkt aus Dicke und Elastizitätsmodul zumindest eines Elements oder eines Verbundes von zumindest zwei Einzelelementen, insbesondere dem Schaltungsträger und/oder dem Abstandselement und/oder dem Träger und/oder der vergossene kapazitive Sensor, größer als 200 MPa mm, vorzugsweise größer als 1800 MPa mm, insbesondere größer als 4000 MPa mm ist.

Der kapazitive Sensor weist zumindest zwei aneinander angrenzende, voneinander isolierte elektrisch leitfähige Flächen auf, die eine elektrische Kapazität derart bilden, dass sich der Wert der Kapazität bei Annäherung eines Objektes ändert. Nach Aufladung der Kapazität bildet sich ein elektrisches Feld in Form von elektrischen Feldlinien zwischen den elektrisch leitfähigen Flächen im Raum zwischen den elektrisch leitfähigen Flächen aus. Bei Annäherung eines Objektes wird dieses elektrische Feld gestört, mithin verändert sich die räumliche Verteilung der elektrischen Feldlinien, so dass sich im Ergebnis bei Annäherung eines Objektes der Wert der Kapazität messbar ändert. Dies hat den Vorteil, dass Objekte bereits bei Annäherung erkannt werden ohne dass eine Berührung des Sensors notwendig ist. Somit werden sich annähernde Objekte frühzeitig erkannt.

Erfindungsgemäß ist der Schaltungsträger, insbesondere die Platine, des kapazitiven Sensors für sich alleine bereits biegesteif und/oder torsionssteif ausgebildet , so dass der gesamte kapazitive Sensor biegesteif und/oder torsionssteif ist. Die biegesteife und/oder torsionssteife Ausbildung des Schaltungsträgers hat den Vorteil, dass dies zu einem kostengünstigen kapazitiven Sensor beiträgt, da der Schaltungsträger ein Massenprodukt und damit ein kostengünstiges Bauteil ist.

Vorteilhaft ist, dass das Abstandselement des kapazitiven Sensors für sich alleine bereits biegesteif und/oder torsionssteif ausgebildet ist, so dass der gesamte kapazitive Sensor biegesteif und/oder torsionssteif ist. Die biegesteife und/oder torsionssteife Ausbildung des Abstandselements zwischen dem Schaltungsträger und den elektrisch leitfähigen Flächen der Kapazitäten hat den Vorteil, dass hierdurch die Biege- und/oder Torsionssteifigkeit kostengünstig herstellbar ist. Dies ist dadurch bedingt, dass die sonstigen Anforderungen an das Abstandselement gering sind und somit ein kostengünstiges Material verwendet werden kann. Besonders vorteilhaft ist die Verwendung eines thermoplastischen Kunststoffs oder eines duroplastischen Kunststoffs. Das Abstandselement weist vorzugsweise eine Dielektrizitätszahl kleiner 1,5, vorzugsweise kleiner 1,1, insbesondere kleiner 1,01 auf. Vorzugsweise besteht das Abstandselement aus aufgeschäumtem Kunststoff und/oder aus Stegen und/oder aus Moosgummi.

Besonders vorteilhaft ist die Ausführungsform einer nicht biegesteifen und/oder torsionssteifen Platine mit einem für sich ebenfalls nicht biegesteifen und/oder torsionssteifen Abstandselement, beispielsweise einem Moosgummi, wobei durch die Verbindung dieser nicht biegesteifen und/oder torsionssteifen Platine mit dem nicht biegesteifen und/oder torsionssteifen Abstandselement, beispielsweise durch Klebung, der Verbund bestehend aus Platine und Abstandselement biegesteif und/oder torsionssteif ist.

Besonders vorteilhaft ist, dass die elektrisch leitfähigen Flächen über elektrisch leitfähige Verbindungen durch das Abstandselement hindurch mit dem Schaltungsträger kontakiert sind, da dies zu einem kompakten Aufbau beiträgt, da keine separate elektrische Verbindungen notwendig sind.

Vorteilhaft ist, dass der Träger des kapazitiven Sensors für sich alleine bereits biegesteif und/oder torsionssteif ausgebildet ist, so dass der gesamte kapazitive Sensor biegesteif und/oder torsionssteif ist. Da zur Herstellung des Trägers etablierte Fertigungsverfahren verwendet werden können, trägt dies dazu bei, dass der kapazitive Sensor kostengünstig herstellbar ist.

Besonders vorteilhaft ist, dass der kapazitive Sensor durch Verguß des kapazitiven Sensors und/oder durch Ausschäumen des kapazitiven Sensors biegesteif und/oder torsionssteif ausgebildet ist. Der Verguß oder das Ausschäumen trägt zusätzlich dazu bei, dass der kapazitive Sensor besonders robust gegen Umwelteinflüsse, wie Feuchtigkeit, ist.

Vorteilhaft ist ferner, dass zumindest zwei der elektrisch leitfähigen Flächen in einem Winkel zwischen 0° und 135°, vorzugsweise in einem Winkel zwischen 45° und 90°, zueinander geneigt sind. Dies trägt dazu bei, dass auch Ecken von Maschinenteilen überwacht werden können.

Erfindungsgemäß weist der kapazitive Sensor vier elektrisch leitfähige Flächen auf, die derart verschaltet sind, das die elektrisch leitfähigen Flächen wenigstens zwei elektrische Kapazitäten bilden, wobei die elektrisch leitfähigen Flächen derart angeordnet sind, dass sich durch elektrische Feldlinien gebildete Erfassungsbereiche der zwei elektrischen Kapazitäten zumindest teilweise überlappen. Dies ermöglicht die redundante Überwachung des selben Raumbereichs und damit die redundante Erkennung der Annäherung eines Objektes durch zwei unabhängige Messanordnungen, so dass auch bei Ausfall einer Messanordnung die Annäherung eines Objektes noch sicher erkannt wird.

In besonders vorteilhafter Weise wird der erfindungsgemäße kapazitive Sensor bei Robotern, insbesondere bei Industrierobotern, verwendet, da hierdurch eine bediensichere Zusammenarbeit von Menschen und bewegten Maschinenteiles des Roboters im gleichen Arbeitsraum zur gleichen Zeit möglich ist. Dies wird dadurch ermöglicht, dass der kapazitive Sensor zum einen im wesentlichen die gesamte Oberfläche der beweglichen Maschinenteile des Roboters bedeckt und zum anderen eine Annäherung eines Objektes sehr frühzeitig ohne die Notwendigkeit eines berührenden Kontaktes erkannt wird.

Weitere Vorteile ergeben sich aus der nachfolgenden Beschreibung von Ausführungsbeispielen mit Bezug zu den Figuren und aus den abhängigen Ansprüchen.

Kurze Beschreibung der Zeichnungen

Ausführungsbeispiele der Erfindung sind in der Zeichnungen anhand mehrerer Figuren dargestellt und in der nachfolgenden Beschreibung näher erläutert.

Es zeigen:

- Fig. 1 den Aufbau eines Sensorelements eines kapazitiven Sensors in einem ersten Ausführungsbeispiel,
- Fig. 2 den Aufbau eines Sensorelements eines kapazitiven Sensors in einem zweiten Ausführungsbeispiel,
- Fig. 3 den Aufbau eines Sensorelements eines kapazitiven Sensors in einem dritten Ausführungsbeispiel,
- Fig. 4 eine Übersichtszeichnung eines Sensorelements zur Veranschaulichung der elektrischen Kontaktierung,
- Fig. 5 den Aufbau eines Sensorsegments eines kapazitiven Sensors,

- Fig. 6 ein Maschinenteil mit einem kapazitiven Sensor in einem ersten Ausführungsbeispiel,
- Fig. 7 ein Maschinenteil mit einem kapazitiven Sensor in einem zweiten Ausführungsbeispiel,
- Fig. 8 ein Maschinenteil mit einem kapazitiven Sensor in einem dritten Ausführungsbeispiel,
- Fig. 9 ein Maschinenteil mit einem kapazitiven Sensor in einem vierten Ausführungsbeispiel, und
- Fig. 10 ein Sensorelement mit einem Objekt.

Beschreibung von Ausführungsbeispielen

Nachfolgend wird ein kapazitiver Sensor zur flächigen Erkennung einer Annäherung eines Objektes beschrieben, wobei der kapazitive Sensor biegesteif und/oder torsionssteif ausgebildet ist. Erfindungsgemäß umfasst der kapazitive Sensor einen Schaltungsträger und ein Abstandselement und vorzugsweise einen Träger. Dabei ist der Schaltungsträger biegesteif und/oder torsionssteif ausgebildet und vorzugsweise ist das Abstandselement biegesteif und/oder torsionssteif ausgebildet und/oder ist der Träger biegesteif und/oder torsionssteif ausgebildet. Der Schaltungsträger ist vorzugsweise als Platine ausgebildet und dient zur elektrischen Kontaktierung der elektrisch leitfähigen Flächen des kapazitiven Sensors. Das Abstandselement ist zwischen den elektrisch leitfähigen Flächen und dem Schaltungsträger angeordnet. Der Träger ist dazu ausgebildet, den kapazitiven Sensor mit einem Maschinenteil, insbesondere eines Maschinenteils eines Industrieroboters, zu verbinden.

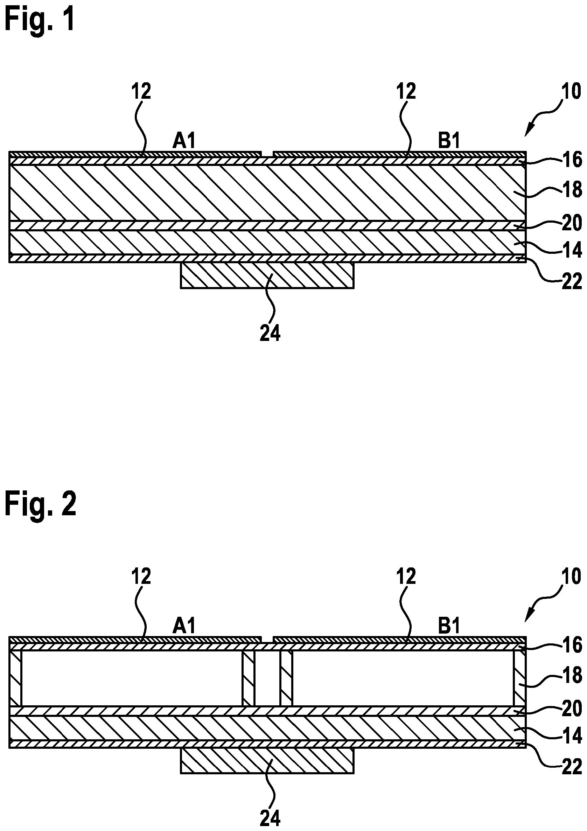

Figur 1 zeigt den Aufbau eines Sensorelements 10 eines kapazitiven Sensors in einem ersten Ausführungsbeispiel. Das Sensorelement 10 besteht aus einem Schichtaufbau, umfassend einen Schaltungsträger 14. In diesem Ausführungsbeispiel ist der Schaltungsträger 14 als biegesteife und torsionssteife Platine ausgebildet. In einer nicht durch die beanspruchte Erfindung abgedeckten

Variante dieses Ausführungsbeispiels ist der Schaltungsträger 14 flexibel als Folie ausgebildet. Die Dicke des Schaltungsträgers beträgt zwischen 30 $\mu$m als Folie und ein bis mehrere Millimeter, vorzugsweise 2 mm, als biegesteife und torsionssteife Platine. Die biegesteife und torsionssteife Platine weist bevorzugt eine Dicke von 500 $\mu$m auf. In diesem Ausführungsbeispiel sind auf der Unterseite des Schaltungsträger 14 fest Leiterbahnen 22 angeordnet, wobei die Leiterbahnen 22 die auf der Oberseite des Sensorelements 10 befindlichen elektrisch leitfähigen Flächen 12 mit nicht gezeigten elektrischen Bauteilen der Auswerteeinheit 24 elektrisch verbinden. Auf der Oberseite des Schaltungsträgers 14 ist eine elektrisch leitfähige Abschirmelektrode 20 angeordnet. Die Abschirmelektrode 20 ist den elektrisch leitfähigen Flächen 12 zugewandt. Die Abschirmelektrode 20 dient zur elektromagnetischen Abschirmung der unter dem Schaltungsträger 14 angeordneten Auswerteeinheit 24. Oben auf der Abschirmelektrode 20 ist ein Abstandselement 18 angeordnet. In diesem Ausführungsbeispiel besteht das Abstandselement 18 aus nicht leitfähigem, flächigem Material (Plattenmaterial), das eine geringe Dielektrizitätszahl aufweist. Vorzugsweise besteht das Abstandselement 18 aus geschäumtem organischem Material und/oder aus geschäumtem anorganischem Material. In diesem Ausführungsbeispiel ist das Abstandselement 18 flexibel ausgeführt. In einer Variante dieses Ausführungsbeispiels ist das Abstandselement biegesteif und/oder torsionssteif ausgebildet. Das Abstandselement 18 stellt den vorgegebenen Abstand zwischen den elektrisch leitfähigen Flächen 12 und der Abschirmelektrode 20 sicher. Oben auf dem Abstandselement 18 ist ein weiterer Schaltungsträger 16 angeordnet. In diesem Ausführungsbeispiel ist der weitere Schaltungsträger 16 als Platine oder als Folie ausgebildet. Auf dem weiteren Schaltungsträger 16 sind elektrisch leitfähige Flächen 12 aufgebracht, die als A1 und B1 markiert sind. Die elektrisch leitfähigen Flächen 12 bestehen aus leitfähigem Material, insbesondere aus Kupfer. In einer Variante dieses Ausführungsbeispiels sind die elektrisch leitfähigen Flächen 12 als massive Flächen aus leitfähigem Material, insbesondere Kupfer, ausgebildet, ohne die Verwendung des weiteren Schaltungsträger 16. Dabei sind die elektrisch leitfähigen Flächen 12 direkt auf der Oberseite des Abstandselements 18 aufgebracht. Die beiden mit A1 und B1 bezeichneten elektrisch leitfähigen Flächen 12 bilden eine elektrische Kapazität, wobei sich zwischen den beiden elektrisch leitfähigen Flächen 12 nach dem elektrischen Aufladen der Kapazität ein elektrisches Feld ausbildet. Falls nun ein Objekt in das elektrische Feld eindringt, ändert sich die Kapazität messbar, so dass die Annäherung eines Objektes erkannt wird. In diesem Ausführungsbeispiel weist das Sensorelement 10 zwei weitere, nicht gezeigte, mit A2 und B2 bezeichnende elektrisch leitfähige Flächen 12 auf. Dabei sind die vier elektrisch leitfähigen Flächen 12 derart angeordnet sind, dass sich durch elektrische Feldlinien gebildete Erfassungsbereiche der zwei elektrischen Kapazitäten zumindest teilweise überlappen. Das Sensorelement 10 ist somit redundant, zweikanalig aufgebaut.

Figur 2 zeigt den Aufbau eines Sensorelements 10 eines kapazitiven Sensors in einem zweiten Ausführungsbeispiel. Das zweite Ausführungsbeispiel stimmt mit dem ersten Ausführungsbeispiel auch in den für das erste Ausführungsbeispiel dargelegten Varianten überein. Lediglich das Abstandselement 18 ist anders aufgebaut. Das Sensorelement 10 des zweiten Ausführungsbeispiels besteht ebenfalls aus zwei, mit A1 und B1 bezeichneten elektrisch leitfähigen Flächen 12, die eine elektrische Kapazität bilden. Die elektrisch leitfähigen Flächen 12 sind entweder über einen weiteren Schaltungsträger 16 oder direkt mit dem Abstandselement 18 verbunden. Ferner umfasst das Sensorelement 10 einen Schaltungsträger 14 mit Leiterbahnen 22, eine Auswerteeinheit 24 und eine Abschirmelektrode 20. In diesem zweiten Ausführungsbeispiel besteht das Abstandselement 18 aus einem Gitter aus nicht leitendem Material, so dass das Gitter keinen störenden Einfluss auf das Wirkprinzip des kapazitiven Sensors hat. In diesem zweiten Ausführungsbeispiel ist das Abstandselement 18 ebenfalls flexibel ausgeführt. In einer Variante dieses zweiten Ausführungsbeispiels ist das Abstandselement biegesteif und/oder torsionssteif ausgebildet. Die Funktionsweise des Sensorelements 10 in dem zweiten Ausführungsbeispiel stimmt mit der Funktionsweise des Sensorelements 10 in dem ersten Ausführungsbeispiel überein. Auch in diesem zweiten Ausführungsbeispiel weist das Sensorelement 10 zwei weitere, nicht gezeigte, mit A2 und B2 bezeichnende elektrisch leitfähige Flächen 12 auf. Dabei sind die vier elektrisch leitfähigen Flächen 12 derart angeordnet sind, dass sich durch elektrische Feldlinien gebildete Erfassungsbereiche der zwei elektrischen Kapazitäten zumindest teilweise überlappen, wobei jeweils die mit A1 und B1, sowie mit A2 und B2 bezeichneten elektrisch leitfähigen Flächen 12 eine Kapazität und damit einen Erfassungsbereich bilden. Das Sensorelement 10 des zweiten Ausführungsbeispiels ist somit ebenfalls redundant, zweikanalig aufgebaut, da sich die von den Kapazitäten erfassten Raumbereiche überlappen.

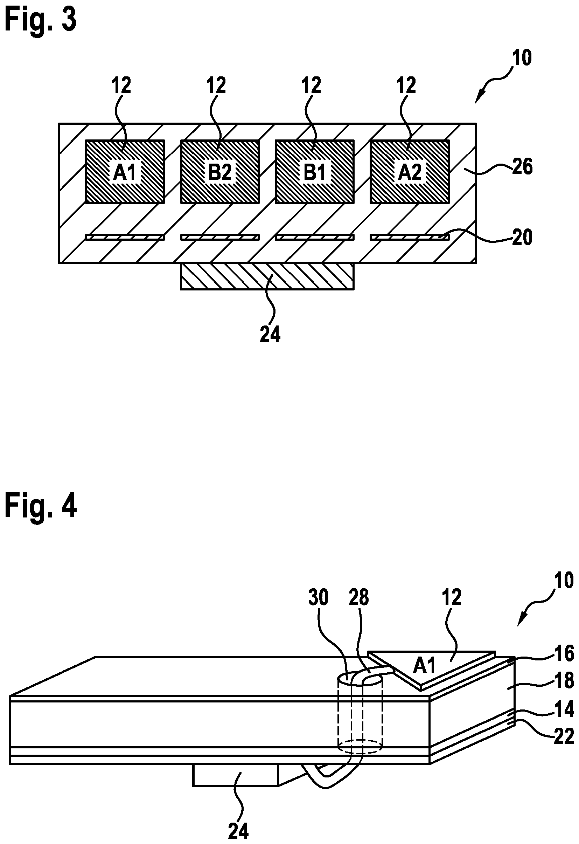

Figur 3 zeigt den Aufbau eines Sensorelements 10 eines kapazitiven Sensors in einem dritten Ausführungsbeispiel. Das dritte Ausführungsbeispiel basiert auf dem ersten Ausführungsbeispiel bzw. dem zweiten Ausführungsbeispiel und stimmt mit diesen bis auf die Verwendung eines Vergussmaterials 26 überein. In diesem dritten Ausführungsbeispiel ist der Sensor-Schichtaufbau, insbesondere die elektrisch leitfähigen Flächen 12 und/oder der Schaltungsträger und/oder der weitere Schaltungsträger und/oder das Abstandselement und/oder die Abschirmelektroden 20 und/oder die Leiterbahnen auf dem Schaltungsträger, starr mit einem aushärtendem Vergussmaterial 26 vergossen, so dass der kapazitive Sensor durch das Vergussmaterial 26 biegesteif und/oder torsionssteif ist. In einer Variante wird alternativ zum Vergussmaterial 26 ein Gel verwendet. Alternativ wird in einer weiteren Variante ein Schaum, insbesondere ein aushärtender Schaum, verwendet, so dass der Sensor-Schichtaufbau ausgeschäumt ist. In einer Variante des dritten Ausführungsbeispiels wird der Sensor-Schichtaufbau, insbesondere die elektrisch leitfähigen Flächen 12 und/oder der Schaltungsträger und/oder der weitere Schaltungsträger und/oder das Abstandselement und/oder die Abschirmelektroden 20 und/oder die Leiterbahnen auf dem Schaltungsträger, alternativ oder ergänzend zu dem Vergussmaterial 26 in ein Gehäuse eingebaut. Das Sensorelement 10 des dritten Ausführungsbeispiels umfasst ebenfalls vier mit A1, A2, B1 und B2 bezeichnete elektrisch leitfähige Flächen 12, wobei jeweils die mit A1 und B1, sowie mit A2 und B2 bezeichneten elektrisch leitfähigen Flächen 12 eine Kapazität und damit einen Erfassungsbereich bilden. Unterhalb dieser elektrisch leitfähigen Flächen 12 sind die Abschirmelektroden 20 angeordnet. Vorzugsweise besteht das Vergussmaterial 26 aus Moosgummi und/oder Schaumstoff und/oder Polyurethan (PU) und/oder Polyethylen (PE) und/oder Polypropylen (PP).

Figur 4 zeigt eine Übersichtszeichnung eines Sensorelements 10 zur Veranschaulichung der elektrischen Kontaktierung nach dem ersten Ausführungsbeispiel. Die beispielhaft eingezeichnete, mit A1 bezeichnete und als Elektrode genutzte elektrisch leitfähige Fläche 12, die mit einer weiteren nicht gezeigten elektrisch leitfähigen Fläche eine Kapazität bildet, ist über einen flexiblen, elektrischen Leiter 28 durch ein Loch 30 im Abstandshalter 18 und/oder durch ein Loch 30 in dem Schaltungsträger 14 mit den unterhalb des Schaltungsträgers 14 angeordneten Leiterbahnen 22 verbunden. Somit ist die elektrisch leitfähige Fläche 12 mit der Auswerteeinheit 24 elektrisch verbunden. Alternativ oder ergänzend wird die elektrische Verbindung zwischen der elektrisch leitfähigen Fläche 12 und den Leiterbahnen 22 durch starre, elektrisch leitende Elemente, insbesondere durch Stifte, und/oder durch Leitkunststoffe hergestellt, wobei die Leitkunststoffe vorzugsweise durch Jetverfahren aufgebracht werden.

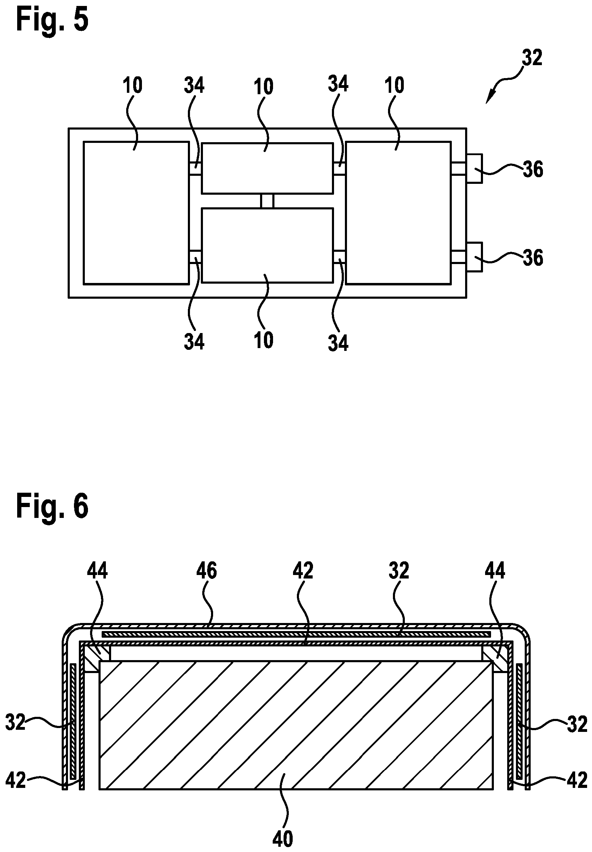

Figur 5 zeigt den Aufbau eines Sensorsegments 32 eines kapazitiven Sensors bestehend aus mehreren Sensorelementen 10, die über elektrische Verbindungen 34 elektrisch und/oder mechanisch miteinander zu einem Sensorsegment 32 verbunden sind. Das Sensorsegment 32 weist mindestens eine elektrische Steckverbindung 36, vorzugsweise zwei elektrische Steckverbindungen 36, auf, die es ermöglicht, das Sensorsegment 32 elektrisch und/oder mechanisch mit weiteren Sensorsegmenten 32 zu verbinden.

Figur 6 zeigt ein Maschinenteil 40 mit einem kapazitiven Sensor in einem ersten Ausführungsbeispiel. In diesem ersten Ausführungsbeispiel des Maschinenteils 40 mit einem kapazitiven Sensor sind Sensorsegmente 32 oder Sensorelemente gemäß den vorhergehenden Ausführungsbeispielen mechanisch mit einem Träger 42 derart zu einem kapazitiven Sensor verbunden, dass die Sensorsegmente 32 bzw. die Sensorelemente bezüglich des Trägers 42 außen liegen und das Maschinenteil 40 vollständig umschließen. Die Sensorsegmente 32 oder die Sensorelemente sind mit dem Träger mechanisch fest verbunden, insbesondere durch Kleben und/oder Schrauben und/oder Klemmen. Die einzelnen Träger 42 sind über Verbinder 44, insbesondere Eckverbinder, miteinander verbunden. Vorzugsweise bestehen die Träger 42 aus einem festen Material, so dass die Träger 42 biegesteif und/oder torsionssteif ausgeführt sind. Die Träger 42 sind mit dem Maschinenteil 40 mechanisch durch Form- und/oder Kraftschluss verbunden. Alternativ oder ergänzend sind die Träger durch Verbindungstechniken, insbesondere durch Schrauben und/oder Klemmen und/oder Kleben und/oder Schweißen, fest mit dem Maschinenteil 40 verbunden. In diesem ersten Ausführungsbeispiel sind die Sensorsegmente 32 oder die Sensorelemente nach außen hin mit einem Schutzelement 46 versehen. Das Schutzelement 46 besteht aus einem Material, das nichtleitend ist und/oder eine geringe Dielektrizitätszahl aufweist und/oder eine geringe Dicke aufweist und/oder eine konstante Dielektrizitätszahl bei sich ändernden Umgebungsbedingungen, insbesondere Temperatur und Feuchtigkeit, sowie bei Alterung des Materials aufweist. Vorzugsweise besteht das Schutzelement 46 aus geschäumtem Kunststoff, insbesondere Polyurethan (PU) und/oder Polyethylen (PE) und/oder Polypropylen (PP), vorzugsweise mit einer Dicke von 2 bis 10 mm, vorzugsweise 4 mm.

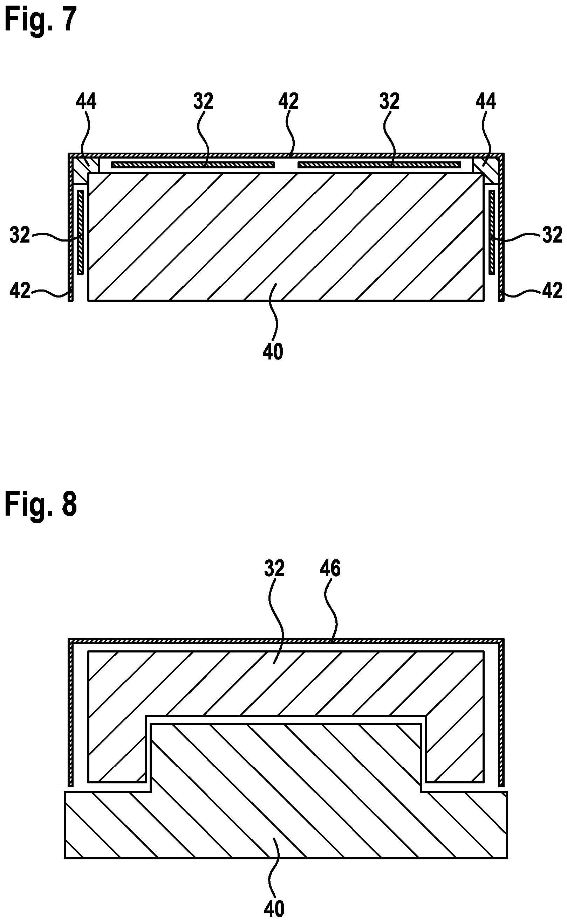

Figur 7 zeigt ein Maschinenteil 40 mit einem kapazitiven Sensor in einem zweiten Ausführungsbeispiel. In diesem zweiten Ausführungsbeispiel des Maschinenteils 40 mit einem kapazitiven Sensor sind Sensorsegmente 32 oder Sensorelemente gemäß den vorhergehenden Ausführungsbeispielen mechanisch mit einem Träger 42 derart zu einem kapazitiven Sensor verbunden, dass die Sensorsegmente 32 bzw. die Sensorelemente bezüglich des Trägers 42 innen liegen und das Maschinenteil 40 umschließen. Die Sensorsegmente 32 oder die Sensorelemente sind mit dem Träger mechanisch fest verbunden, insbesondere durch Kleben und/oder Schrauben und/oder Klemmen. Die einzelnen Träger 42 sind über Verbinder 44, insbesondere Eckverbinder, miteinander verbunden. Die Träger 42 sind mit dem Maschinenteil 40 mechanisch durch Form- und/oder Kraftschluss verbunden. Alternativ oder ergänzend sind die Träger durch Verbindungstechniken, insbesondere durch Schrauben und/oder Klemmen und/oder Kleben und/oder Schweißen, fest mit dem Maschinenteil 40 verbunden. Alternativ oder zusätzlich sind die Träger 42 mit den Verbindern 44 verbunden, wobei die Verbinder 44 mechanisch durch Form- und/oder Kraftschluss mit dem Maschinenteil 40 verbunden sind. In diesem zweiten Ausführungsbeispiel besteht der Träger 42 aus einem Material, das nichtleitend ist und/oder eine geringe Dielektrizitätszahl aufweist und/oder eine geringe Dicke aufweist und/oder eine konstante Dielektrizitätszahl bei sich ändernden Umgebungsbedingungen, insbesondere Temperatur und Feuchtigkeit, sowie bei Alterung des Materials aufweist. Vorzugsweise bestehen die Träger 42 aus einem festen Material, so dass die Träger 42 biegesteif und/oder torsionssteif ausgeführt sind. Besonders bevorzugt bestehen die Träger 42 aus Polycarbonat oder Polypropylen, vorzugsweise mit einer Dicke zwischen 1 und 10 mm, vorzugsweise 2 mm, besonders bevorzugt 3 mm.

Vorzugsweise sind die Träger 42 und/oder die Sensorsegmente 32 und/oder die Sensorelemente der vorstehenden Ausführungsbeispiele eben. Alternativ bilden Träger 42 und/oder die Sensorsegmente 32 und/oder die Sensorelemente der vorstehenden Ausführungsbeispiele beliebig geformte Flächen.

Die Biegesteifigkeit und/oder Torsionssteifigkeit des kapazitiven Sensors wird durch einen biegesteifen und/oder torsionssteifen Träger und/oder durch einen biegesteifen und/oder torsionssteifen Schaltungsträger und/oder durch ein biegesteifes und/oder torsionssteifes Abstandselement und/oder einer Kombination dieser Elemente erreicht.

Figur 8 zeigt ein Maschinenteil 40 mit einem kapazitiven Sensor in einem dritten Ausführungsbeispiel, wobei das Sensorsegment 32 gemäß der Figur 3 ausgebildet ist, insbesondere mit einem Vergussmaterial vergossen ist. Die Sensorsegmente 32 oder Sensorelemente sind mit dem Maschinenteil 40 mechanisch durch Form- und/oder Kraftschluss verbunden. Alternativ oder ergänzend sind die Sensorsegmente 32 oder Sensorelemente durch Verbindungstechniken, insbesondere durch Schrauben und/oder Klemmen und/oder Kleben und/oder Schweißen, fest mit dem Maschinenteil 40 verbunden. In diesem dritten Ausführungsbeispiel des Maschinenteils 40 mit einem kapazitiven Sensor sind die Sensorsegmente 32 oder die Sensorelemente nach außen hin mit einem Schutzelement 46 versehen. Das Schutzelement 46 besteht aus einem Material, das nichtleitend ist und/oder eine geringe Dielektrizitätszahl aufweist und/oder eine geringe Dicke aufweist und/oder eine konstante Dielektrizitätszahl bei sich ändernden Umgebungsbedingungen, insbesondere Temperatur und Feuchtigkeit, sowie bei Alterung des Materials aufweist.

Die als Elektroden ausgebildeten elektrisch leitfähigen Flächen sind vorzugsweise viereckig ausgebildet. Alternative oder zusätzlich sind die elektrisch leitfähigen Flächen als Dreiecke ausgebildet. In einer weiteren Variante sind die elektrisch leitfähigen Flächen rund und/oder als Vielecke ausgebildet. Vorzugsweise sind die Sensorelemente 2-kanalig ausgeführt mit zumindest drei, vorzugsweise 4, elektrisch leitfähigen Flächen, die derart angeordnet und verschaltet sind, dass die elektrischen Feldlinien der zumindest zwei durch die Verschaltung der elektrisch leitfähigen Flächen gebildeten Kapazitäten einen gemeinsamen Raumbereich abdecken.

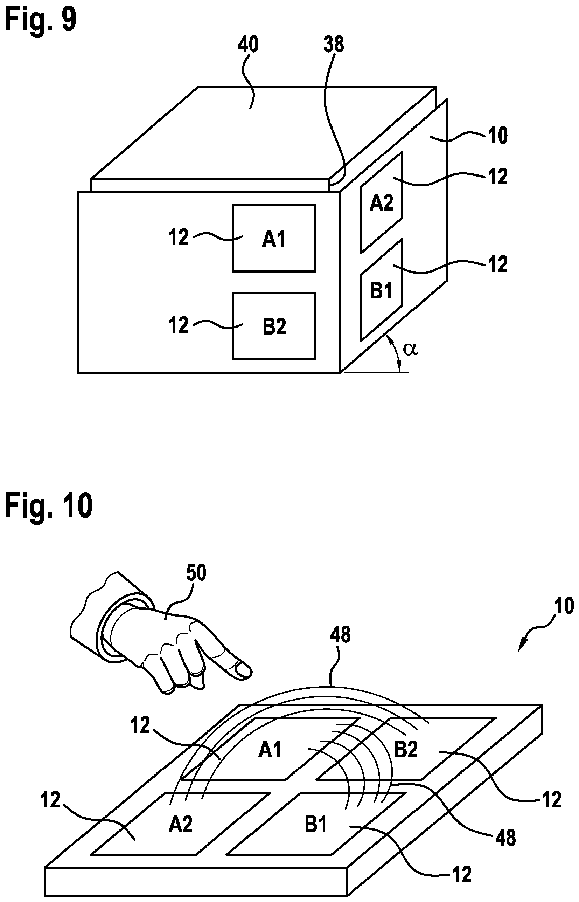

Figur 9 zeigt ein Maschinenteil 40 mit einem kapazitiven Sensor in einem vierten Ausführungsbeispiel. In diesem vierten Ausführungsbeispiel sind die mit A1, B1, A2 und B2 bezeichneten elektrisch leitfähigen Flächen 12 (Elektroden) nicht in einer Ebene sondern jeweils zwei Elektroden auf einer ersten Ebene und die zwei weiteren Elektroden auf einer zweiten Ebene, die zur ersten Ebene geneigt ist, vorzugsweise mit einem Winkel $\alpha$ zwischen 0° und 135°, insbesondere zwischen 45° und 90°, angeordnet. Bevorzugt bilden die Elektroden A1/B1 und A2/B2 eine Kapazität aus, so dass der Raumbereich der Kante 38 des Maschinenteils 40 2-kanalig auf eine Annäherung eines Objektes überwacht wird. In einer weiteren Variante sind die elektrisch leitfähigen Flächen 12 gekrümmte Flächen und/oder sind die elektrisch leitfähigen Flächen 12 auf gekrümmten Flächen des Maschinenteils 40 angebracht.

Figur 10 zeigt ein Sensorelement 10 mit einem Objekt 50. Das Sensorelement 10 weist vier mit A1, A2, B1 und B2 bezeichnete elektrisch leitfähige Flächen 12 auf. Dabei bilden die mit A1 und B1 bezeichneten elektrisch leitfähigen Flächen 12 eine erste Kapazität. Nach Anlegen einer Spannung zwischen denen mit A1 und B1 bezeichneten elektrisch leitfähigen Flächen 12 bildet sich zwischen diesen elektrisch leitfähigen Flächen 12 ein elektrisches Feld mit Feldlinien 48 aus. Entsprechend bilden die mit A2 und B2 bezeichneten elektrisch leitfähigen Flächen 12 eine zweite Kapazität. Nach Anlegen einer Spannung zwischen denen mit A2 und B2 bezeichneten elektrisch leitfähigen Flächen 12 bildet sich zwischen diesen elektrisch leitfähigen Flächen 12 ebenfalls ein elektrisches Feld mit Feldlinien 48 aus. Dabei ist es vorzugsweise vorgesehen, dass das elektrische Feld der beiden Kapazitäten zeitlich abwechselnd ausgebildet wird. In einer Variante ist es vorgesehen, dass das elektrische Feld der beiden Kapazitäten zum gleichen Zeitpunkt ausgebildet ist. Bei Annäherung eines Objektes 50 verändert sich die Kapazität zwischen den beiden elektrisch leitfähigen Flächen 12, so dass die Annäherung des Objektes 50 detektiert wird. Dabei ist es nicht notwendig, dass das Objekt 50 das Sensorelement 10 berührt, vielmehr tritt die Änderung der Kapazität abhängig von der Größe der elektrisch leitfähigen Flächen 12 bereits bei einer Annäherung des Objektes 50 an die elektrisch leitfähigen Flächen auf. Dabei ist der Erfassungsbereich des Sensors etwa so groß wie der Abstand der beiden Elektroden. Vorzugsweise liegt der Erfassungsbereich zwischen 1 mm und 300 mm.

Nachfolgend wird beispielshaft bei Verwendung des kapazitiven Sensors bei einem Roboter erläutert, wie ein Sensorelement eine Annäherung eines Objektes, insbesondere eines menschlichen Körperteils, anhand der Veränderung des Wertes der Kapazität eines Kondensators erfasst, wobei der Kondensator durch die beiden elektrisch leitfähigen Flächen und den offenen Feldraum als Dielektrikum gebildet wird. Bei einer Initialisierung des Sensorelements werden die zu überwachenden Kapazitäten gemessen und einmalig als Startwerte $C_{ij0}$ abgespeichert. Während des Betriebes werden die zu überwachenden Kapazitäten $C_{ij}$ zyklisch in konstantem Zeitraster, typischerweise 100Hz - 1000Hz, gemessen. Durch eine Auswertung dieser Daten kann die Information über eine Annäherung abgeleitet werden.

Im Folgenden werden zwei bevorzugte Verfahren beschrieben, die sich gegenseitig ergänzen und daher beide simultan eingesetzt werden können. Eine Annäherung wird gemeldet, wenn mindestens eines der Verfahren eine Annäherung erkennt.

a) statische Annäherungserkennung

Eine Annäherung wird erkannt, wenn für mindestens eine Kapazität $C_{ij}$ gilt

$$| (C_{ij} - C_{ij0}) / C_{ij0} | > T_{stat}$$

     ; $C_{ij}$: aktueller Kapazitätsmesswert

     ; $C_{ij0}$: bei Initialisierung abgespeicherter Messwert

     ; $T_{stat}$: applizierbarer Schwellwert, Einheit: %.

Das heißt, wenn mindestens ein Kapazitätsmesswert $C_{ij}$ um mehr als $T_{stat}$ von seinem Initialisierungswert abweicht, wird eine Annäherung erkannt, wobei ein typischer Wertebereich für $T_{stat}$ 10% - 50% ist.

b) dynamische Annäherungserkennung

Eine Annäherung wird erkannt, wenn für mindestens eine Kapazität $C_{ij}$ gilt

$$d (C_{ij} / C_{ij0}) / dt > T_{dyn}$$

     ; dt: Beobachtungszeitraum

     ; $T_{dyn}$: applizierbarer Schwellwert, Einheit: % / s

Das heißt, wenn mindestens ein Kapazitätsmesswert $C_{ij}$ in einem beliebigen Zeitraum dt eine Veränderung von mehr als ($T_{dyn}$ * dt) aufweist, wird eine Annäherung erkannt, wobei ein typischer Wertebereich für dt 0,1s - 1s und für $T_{dyn}$ 10%/s - 100%/s ist. Die Werte für $T_{dyn}$ und $T_{stat}$ werden bei der Systemapplikation festgelegt.

Typischerweise können einheitliche Daten für eine Vielzahl von Sensorelementen verwendet werden, wobei in Sonderfällen auch eine individuelle Festlegung der Grenzwerte für einzelne Sensorelemente vorgesehen werden kann.

Da die Kapazitätsänderung bei einer Annäherung überproportional zunimmt, bewirkt die dynamische Annäherungserkennung bei großen Geschwindigkeiten einen großen Schaltabstand und bei kleinen Geschwindigkeiten einen kleinen Schaltabstand. Dies kommt der physikalischen Gesetzmäßigkeit entgegen, dass bei hohen Geschwindigkeiten größere Bremswege erforderlich sind. Somit wird durch die Dynamikfunktion ein kollisionsfreier Betrieb des Roboters begünstigt.

Gleichzeitig wird eine Fehlauslösung bei niedrigen Geschwindigkeiten vermieden, da eine langsame Kapazitätsänderung nicht zum Überschreiten des Schwellwertes $T_{dyn}$ führt. So führt beispielsweise ein bestimmungsgemäß langsam laufendes Maschinenteil in der Nähe des kapazitiven Sensors nicht zur Fehlauslösung.

Die statische Annäherungserkennung verhindert auch bei niedrigen Geschwindigkeiten eine Quetschung von Körperteilen, da bei Unterschreiten des durch $T_{stat}$ festgelegten Minimalabstandes immer ein sicherer Maschinenhalt erfolgt.

Bei einer bestimmten Änderungsgeschwindigkeit der Kapazität und/oder, wenn die Kapazität die zuvor angesprochenen Grenzwerte unter- bzw. überschreitet, wird daraus auf eine kollisionsgefährdende Annäherung zwischen dem Sensorelement und einem Objekt, beispielsweise einem Menschen, geschlossen.

Schaltungsteile der Auswerteeinheiten der Sensorelemente wandeln die gemessenen Werte der Kapazitäten in elektrische Signale um und übertragen diese an eine in den Figuren nicht gezeigte zentrale Steuereinheit. Vorzugsweise führen die Auswerteeinheiten eine zyklische Eigendiagnose zur Überprüfung aller sicherheitsrelevanten Funktionen des Sensorelements durch.

Alle Auswerteeinheiten der Sensorelemente sind über elektrische Leitungen zur Energie- und Datenübertragung mit der zentralen Steuereinheit verbunden.

Eine Mehrzahl aneinander gereihte Sensorelemente oder Sensorsegmente bilden vorzugsweise einen flächigen kapazitiven Sensor, der die äußere Oberfläche eines Maschinenteils, insbesondere eines Roboters, besonders bevorzugt einen Roboterarm als Maschinenteil, derart vollflächig bedeckt, dass die räumliche Umgebung des Maschinenteils auf die Annäherung eines Objektes überwachbar ist.

Der beschriebene kapazitive Sensor bzw. die Sensorsegmente bzw. die Sensorelemente können in unterschiedlichen Anwendungsbereichen eingesetzt werden, beispielsweise bei Robotern, insbesondere bei Industrierobotern oder Servicerobotern, sowie mobilen Plattformen, Fahrzeugen, insbesondere unbemannten Fahrzeugen, in der Medizintechnik und/oder in der Unterhaltungsindustrie.

**Patentansprüche**

1. Kapazitiver Sensor zur flächigen Erkennung einer Annäherung eines Objektes (50), wobei der kapazitive Sensor eine erste und eine zweite seitlich beanstandet angeordnete, angrenzende, voneinander isolierte elektrisch leitfähige Fläche (12, A1, B1) aufweist, die eine erste elektrische Kapazität derart bilden, dass sich der Wert der ersten elektrischen Kapazität bei Annäherung des Objektes ändert, um somit einen ersten Erfassungsbereich zu bilden, wobei nach Aufladung der ersten elektrischen Kapazität ein elektrisches Feld zwischen der ersten und der zweiten elektrisch leitfähigen Fläche (12, A1, B1) ausgebildet ist und wobei der kapazitive Sensor eine dritte und eine vierte elektrisch leitfähige Fläche (12, A2, B2) aufweist, die derart verschaltet sind, dass die dritte und die vierte elektrisch leitfähige Fläche (12, A2, B2) eine zweite elektrische Kapazität derart bilden, dass sich der Wert der zweiten elektrischen Kapazität bei Annäherung eines Objektes ändert um somit einen zweiten Erfassungsbereich zu bilden, wobei jeweils die erste, zweite, dritte und vierte elektrisch leitfähige Fläche (12, A1, B1, A2, B2) derart angeordnet ist, dass sich jeweils der erste und der zweite Erfassungsbereich zumindest teilweise überlappen, **dadurch gekennzeichnet, dass** der kapazitive Sensor biegesteif und/oder torsionssteif ausgebildet ist, dass der kapazitive Sensor einen Schaltungsträger (14) aufweist, wobei der Schaltungsträger (14) biegesteif und/oder torsionssteif ausgebildet ist und dass der kapazitive Sensor ein Abstandselement (18) aufweist, wobei das Abstandselement zwischen den leitfähigen Flächen (12, A1, B1, A2, B2) und dem Schaltungsträger (14) angeordnet ist.

2. Kapazitiver Sensor nach Anspruch 1, **dadurch gekennzeichnet, dass** der Schaltungsträger (14) als Platine mit Leiterbahnen (22) ausgebildet ist, wobei der Schaltungsträger (14) die elektrisch leitfähigen Flächen (12) mit elektrischen Bauteilen kontaktiert.

3. Kapazitiver Sensor nach dem vorhergehenden Anspruch, **dadurch gekennzeichnet, dass** die elektrisch leitfähigen Flächen (12) über elektrisch leitfähige Verbindungen durch das Abstandelement (18) hindurch mit dem Schaltungsträger (14) kontaktiert sind.

4. Kapazitiver Sensor nach einem der vorhergehenden Ansprüche, **dadurch gekennzeichnet, dass** der kapazitive Sensor einen Träger (42) aufweist, wobei der Träger (42) biegesteif und/oder torsionssteif ausgebildet ist.

5. Kapazitiver Sensor nach einem der vorhergehenden Ansprüche, **dadurch gekennzeichnet, dass** der Träger (42) derart ausgestaltet ist, dass der kapazitive Sensor über den Träger (42) mit einem Maschinenteil (40) verbindbar ist.

6. Kapazitiver Sensor nach Anspruch 2, **dadurch gekennzeichnet, dass** der kapazitive Sensor einen weiteren Schaltungsträger (16) aufweist, wobei der weitere Schaltungsträger (16) als Platine oder Folie ausgebildet ist, wobei die elektrisch leitfähigen Flächen (12) auf dem weiteren Schaltungsträger (16) angeordnet sind.

7. Kapazitiver Sensor nach einem der vorhergehenden Ansprüche, **dadurch gekennzeichnet, dass** der kapazitive Sensor erst durch Verguß des kapazitiven Sensors und/oder durch Ausschäumen des kapazitiven Sensors und/oder durch ein Einbetten des kapazitiven Sensors in ein Gel biegesteif und/oder torsionssteif ist.

8. Kapazitiver Sensor nach einem der vorhergehenden Ansprüche, **dadurch gekennzeichnet, dass** der kapazitive Sensor aus einem Verbund von wenigstens zwei unterschiedlichen Schichten besteht, wobei jede Schicht für sich biegsam ist und wobei erst durch den Verbund der zwei unterschiedlichen Schichten der kapazitive Sensor biegesteif und/oder torsionssteif ist, wobei die Schicht insbesondere ein Schaltungsträger und/oder ein Abstandselement und/oder ein Träger und/oder ein weiterer Schaltungsträger ist.

9. Kapazitiver Sensor nach einem der vorhergehenden Ansprüche, **dadurch gekennzeichnet, dass** zumindest zwei der elektrisch leitfähigen Flächen (12) in einem Winkel zwischen 0° und 135°, vorzugsweise in einem Winkel zwischen 45° und 90°, zueinander geneigt sind.

10. Kapazitiver Sensor nach einem der vorhergehenden Ansprüche, **dadurch gekennzeichnet, dass** das Abstandselement des kapazitiven Sensors für sich alleine bereits biegesteif und/oder torsionssteif ausgebildet ist so dass der gesamte kapazitive Sensor biegesteif und/oder torsionssteif ist.

11. Kapazitiver Sensor nach einem der vorhergehenden Ansprüche, **dadurch gekennzeichnet, dass** das Abstandselement eine Dielektrizitätszahl kleiner 1,5. Vorzugsweise kleiner 1,1 aufweist.

12. Kapazitiver Sensor nach einem der vorhergehenden Ansprüche, **dadurch gekennzeichnet, dass** der Schaltungsträger als biegesteife und torsionsfeste Platine ausgebildet ist und wobei auf einer Oberseite des Schaltungsträgers eine elektrische Abschirmelektrode angeordnet ist, wobei die Abschirmelektrode den elektrisch leitfähigen Flächen zugewandt ist.

13. Maschinenteil (40), insbesondere eines Industrieroboters, mit mehreren kapazitiven Sensoren nach einem der vorhergehenden Ansprüche, wobei die kapazitiven Sensoren die äußere Oberfläche des Maschinenteils (40) derart vollflächig bedecken, dass eine räumliche Umgebung des Maschinenteils (40) auf die Annäherung eines Objektes (50) überwachbar ist.

**Claims**

1. Capacitive sensor for areally identifying an approach by an object (50), wherein the capacitive sensor has a first and a second adjoining, electrically conductive area (12, A1, B1) which are insulated from one another and are arranged laterally at a distance from one another and form a first electrical capacitance in such a way that the value of the first electrical capacitance changes when the object approaches in order to thereby form a first detection region, wherein, after charging of the first electrical capacitance, an electric field is formed between the first and the second electrically conductive area (12, A1, B1), and wherein the capacitive sensor has a third and a fourth electrically conductive area (12, A2, B2) which are interconnected in such a way that the third and the fourth electrically conductive area (12, A2, B2) form a second electrical capacitance in such a way that the value of the second electrical capacitance changes when an object approaches in order to thereby form a second detection region, wherein the first, second, third and fourth electrically conductive area (12, A1, B1, A2, B2) are each arranged in such a way that the first and the second detection region at least partially overlap in each case, **characterized in that** the capacitive sensor is of flexurally rigid and/or torsionally rigid design, **in that** the capacitive sensor has a circuit carrier (14), wherein the circuit carrier (14) is of flexurally rigid and/or torsionally rigid design, and **in that** the capacitive sensor has a spacer element (18), wherein the spacer element is arranged between the conductive areas (12, A1, B1, A2, B2) and the circuit carrier (14).

2. Capacitive sensor according to Claim 1, **characterized in that** the circuit carrier (14) is designed as a printed circuit board with conductor tracks (22), wherein the circuit carrier (14) contact-connects the electrically conductive areas (12) to electrical components.

3. Capacitive sensor according to the preceding claim, **characterized in that** the electrically conductive areas (12) are contacted by the circuit carrier (14) via electrically conductive connections through the spacer element (18).

4. Capacitive sensor according to one of the preceding claims, **characterized in that** the capacitive sensor has a carrier (42), wherein the carrier (42) is of flexurally rigid and/or torsionally rigid design.

5. Capacitive sensor according to one of the preceding claims, **characterized in that** the carrier (42) is configured in such a way that the capacitive sensor can be connected to a machine part (40) by means of the carrier (42).

6. Capacitive sensor according to Claim 2, **characterized in that** the capacitive sensor has a further circuit carrier (16), wherein the further circuit carrier (16) is designed as a printed circuit board or foil, wherein the electrically conductive areas (12) are arranged on the further circuit carrier (16).

7. Capacitive sensor according to one of the preceding claims, **characterized in that** the capacitive sensor is flexurally rigid and/or torsionally rigid only by way of potting the capacitive sensor and/or by way of foam-filling the capacitive sensor and/or by way of embedding the capacitive sensor in a gel.

8. Capacitive sensor according to one of the preceding claims, **characterized in that** the capacitive sensor consists of a combination of at least two different layers, wherein each layer is inherently flexible and wherein the capacitive sensor is flexurally rigid and/or torsionally rigid only owing to the combination of the two different layers, wherein the layer is, in particular, a circuit carrier and/or a spacer element and/or a carrier and/or a further circuit carrier.

9. Capacitive sensor according to one of the preceding claims, **characterized in that** at least two of the electrically conductive areas (12) are inclined with respect to one another at an angle of between 0° and 135°, preferably at an angle of between 45° and 90°.

10. Capacitive sensor according to one of the preceding claims, **characterized in that** the spacer element of the capacitive sensor itself is already of flexurally rigid and/or torsionally rigid design, so that the entire capacitive sensor is flexurally rigid and/or torsionally rigid.

11. Capacitive sensor according to one of the preceding claims, **characterized in that** the spacer element has a dielectric constant of less than 1.5, preferably of less than 1.1.

12. Capacitive sensor according to one of the preceding claims, **characterized in that** the circuit carrier is designed as a flexurally rigid and torsionally fixed printed circuit board, and wherein an electrical shielding electrode is arranged on a top side of the circuit carrier, wherein the shielding electrode faces the electrically conductive areas.

13. Machine part (40), in particular of an industrial robot, having a plurality of capacitive sensors according to one of the preceding claims, wherein the capacitive sensors cover the entire outer surface of the machine part (40) in such a way that a spatial area surrounding the machine part (40) can be monitored for the approach of an object (50).

**Revendications**

1. Capteur capacitif destiné à la reconnaissance en surface d'une approche d'un objet (50),

le capteur capacitif présentant une première et une deuxième surface électriquement conductrices (12, A1, B1), isolées l'une par rapport à l'autre, contiguës, disposées de manière latéralement espacée, et qui forment une première capacité électrique de telle sorte que la valeur de la première capacité électrique varie à l'approche de l'objet afin de former ainsi une première zone de détection,
dans lequel, après chargement de la première capacité électrique, un champ électrique est réalisé entre la première et la deuxième surface électriquement conductrice (12, A1, B1), et dans lequel le capteur capacitif présente une troisième et une quatrième surface électriquement conductrice (12, A2, B2) qui sont connectées de telle sorte que la troisième et la quatrième surface électriquement conductrice (12, A2, B2) forment une deuxième capacité électrique de telle sorte que la valeur de la deuxième capacité électrique varie à l'approche d'un objet afin de former ainsi une deuxième zone de détection, dans lequel respectivement la première, la deuxième, la troisième et la quatrième surface électriquement conductrice (12, A1, B1, A2, B2) sont disposées de telle sorte que respectivement la première et la deuxième zone de détection se chevauchent au moins partiellement,
**caractérisé en ce que** le capteur capacitif est réalisé de manière rigide en flexion et/ou en torsion, **en ce que** le capteur capacitif présente un support de circuit (14), le support de circuit (14) étant réalisé de manière rigide en flexion et/ou en torsion, et **en ce que** le capteur capacitif présente un élément d'écartement (18), l'élément d'écartement étant disposé entre les surfaces conductrices (12, A1, B1, A2, B2) et le support de circuit (14).

2. Capteur capacitif selon la revendication 1, **caractérisé en ce que** le support de circuit (14) est réalisé sous la forme d'une carte de circuit à pistes conductrices (22), le support de circuit (14) mettant en contact les surfaces électriquement conductrices (12) avec des composants électriques.

3. Capteur capacitif selon la revendication précédente, **caractérisé en ce que** les surfaces électriquement conductrices (12) sont mises en contact par des connexions électriquement conductrices avec le support de circuit (14) à travers l'élément d'écartement (18).

4. Capteur capacitif selon l'une quelconque des revendications précédentes, **caractérisé en ce que** le capteur capacitif présente un support (42), le support (42) étant réalisé de manière rigide en flexion et/ou en torsion.

5. Capteur capacitif selon l'une quelconque des revendications précédentes, **caractérisé en ce que** le support (42) est configuré de telle sorte que le capteur capacitif peut être relié à une partie de machine (40) par l'intermédiaire du support (42).

6. Capteur capacitif selon la revendication 2, **caractérisé en ce que** le capteur capacitif présente un support de circuit supplémentaire (16), le support de circuit supplémentaire (16) étant réalisé sous la forme d'une carte de circuit ou d'un film, les surfaces électriquement conductrices (12) étant disposées sur le support de circuit supplémentaire (16).

7. Capteur capacitif selon l'une quelconque des revendications précédentes, **caractérisé en ce que** le capteur capacitif n'est rendu rigide en flexion et/ou en torsion que par le scellement du capteur capacitif et/ou par le moussage du capteur capacitif et/ou par une incorporation du capteur capacitif dans un gel.

8. Capteur capacitif selon l'une quelconque des revendications précédentes, **caractérisé en ce que** le capteur capacitif est composé d'un assemblage d'au moins deux couches différentes, chaque couche étant flexible en soi, et dans lequel, seul l'assemblage des deux couches différentes rend le capteur capacitif rigide en flexion et/ou en torsion, la couche étant en particulier un support de circuit et/ou un élément d'écartement et/ou un support et/ou un support de circuit supplémentaire.

9. Capteur capacitif selon l'une quelconque des revendications précédentes, **caractérisé en ce qu'**au moins deux des surfaces électriquement conductrices (12) sont inclinées l'une par rapport à l'autre selon un angle compris entre 0° et 135°, de préférence selon un angle compris entre 45° et 90°.

10. Capteur capacitif selon l'une quelconque des revendications précédentes, **caractérisé en ce que** l'élément d'écartement du capteur capacitif en tant que tel est déjà réalisé de manière rigide en flexion et/ou en torsion de sorte que le capteur capacitif tout entier est rigide en flexion et/ou en torsion.

11. Capteur capacitif selon l'une quelconque des revendications précédentes, **caractérisé en ce que** l'élément d'écartement présente une constante diélectrique inférieure à 1,5, de préférence inférieure à 1, 1.

12. Capteur capacitif selon l'une quelconque des revendications précédentes, **caractérisé en ce que** le support de circuit est réalisé sous la forme d'une carte de circuit rigide en flexion et en torsion, et une électrode de blindage électrique étant disposée sur une face supérieure du support de circuit, l'électrode de blindage étant tournée vers les surfaces électriquement conductrices.

13. Partie de machine (40), en particulier d'un robot industriel, comprenant plusieurs capteurs capacitifs selon l'une quelconque des revendications précédentes, dans laquelle les capteurs capacitifs recouvrent la surface extérieure de la partie de machine (40) sur toute la surface de telle sorte qu'un environnement spatial de la partie de machine (40) peut être surveillé quant à l'approche d'un objet (50).

**Fig. 1**

**Fig. 2**

**Fig. 3**

**Fig. 4**

**Fig. 5**

**Fig. 6**

## Fig. 7

## Fig. 8

## Fig. 9

## Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009029021 A1
- DE 102010064328 A1
- US 2006097734 A1
- US 2013106702 A1
- US 2013342224 A
- US 2010026656 A